# EUROPEAN PATENT APPLICATION

(11) **EP 2 369 037 A1**
(43) Date of publication of application: **28.09.2011**
(21) Application number: 11250296.8
(22) Date of filing: 11.03.2011
(51) Int. Cl.: C23C 14/54, C23C 4/12

(54) **Coating method and apparatus**

(30) Priority: 12.03.2010 US 723412
(71) Applicant: United Technologies Corporation, Hartford, CT 06101 (US)
(72) Inventor: Gero, Peter F., Portland, CT 06480 (US); Schlichting, Kevin W., South Glastonbury, CT 06073 (US); Neal, James W., Ellington, CT 06029 (US)
(74) Representative: Tomlinson, Kerry John

(57) **Abstract**

A coating system includes a first work piece (26A), a work piece support (18) for holding the first work piece, a plasma-based coating delivery apparatus (14) configured to apply a coating material to the first work piece in a plasma-based vapor stream, and a first electron gun (20A) configured to direct a first electron beam at the first work piece while the plasma-based coating delivery apparatus applies the coating to the first work piece for heating the first work piece being coated, wherein the first electron gun is configured to direct the first electron beam at a region of the first work piece facing away from the plasma-based coating delivery apparatus.

## Description

The present invention relates to coating apparatuses and methods of applying coatings.

Coatings are utilized in a variety of settings to provide a variety of benefits. For example, modem gas turbine engines can include thermal barrier coatings (TBCs), environmental coatings, etc. to help promote efficient and reliable operation. Application of coatings can involve a variety of different application methods, such as plasma-based physical vapor deposition (PVD). When TBCs are applied to gas turbine engine components, such as blades and vanes, using plasma-based-PVD, the components being coated are rotated within a process chamber while a plasma stream directs the coating material at the components. Examples of such known coating processes are disclosed in U.S. Pat. No. 7,482,035 and in U.S. Pat. App. Pub. Nos. 2007/0259173A1 and 2008/0226837A1.

A significant problem with known plasma-based PVD processes is the loss of work-piece temperature to down-stream portions of the plasma-based PVD equipment. A plasma gun generating the plasma stream is the only source of heat in the system. The walls of the process chamber are typically cooled to approximately 15-20°C, and thereby remove heat from the process chamber, and a downstream end of the process chamber includes equipment to collect and cool excess coating material, thereby also removing thermal energy from the process chamber. Components being coated tend to be cyclically heated and cooled as they rotate because portions of the components that face downstream and away from the plasma stream cool to lower temperatures. TBCs are sensitive to thermal conditions during the coating application process, and undesirable thermal conditions can cause detrimental changes to the microstructure of the TBC. In particular, the TBC develops striations and a cauliflower-like structure due to poor temperature control. While in a typical application it is desired to maintain the components being coated at a temperature of approximately 1038°C (1900°F), temperatures can range from approximately 871-1093°C (1600-2000°F). Moreover, as portions of the components being coated are rotated back to face the plasma stream, separation between new, hot layers of the coating and the cooler interface of previously-applied coating material can make the resultant coating undesirably friable and prone to separation between layers of the coating. These microstructural characteristics are known to cause a debit in service life for the turbine engine component, such as through an increased risk of spallation.

One approach known in the art for providing temperature control involves passive thermal shielding. However, passive thermal shielding mitigates only off-axis heat loss to a relatively cold process chamber. The core reason for this effect is the flow-through nature of the coating vapor stream created via the plasma stream. Laterally-oriented passive spray shielding is incapable of ensuring heat-loss from down-stream areas of the process chamber where the plasma plume and waste ceramic vapor are cooled and collected for extraction from the process chamber.

Thus, it is desired to provide a coating apparatus and method with improved thermal stabilization.

### SUMMARY

A coating system according to the present invention includes a first work piece, a work piece support for holding the first work piece, a plasma-based coating delivery apparatus configured to apply a coating material to the first work piece in a plasma-based vapor stream, and a first electron gun configured to direct a first electron beam at the first work piece while the plasma-based coating delivery apparatus applies the coating to the first work piece for heating the first work piece being coated, wherein the first electron gun is configured to direct the first electron beam at a region of the first work piece facing away from the plasma-based coating delivery apparatus.

### BRIEF DESCRIPTION OF THE DRAWINGS

FIG. 1 is a schematic cross-sectional view of a coating apparatus according to the present invention.

FIG. 2 is a flow chart illustrating a coating method according to the present invention.

### DETAILED DESCRIPTION

In general, the present invention provides an apparatus and method for coating work pieces while providing direct thermal stabilization to those work pieces. An electron beam is directed at a work piece to help promote thermal stability during coating. The electron beam can be directed at a region of the work piece facing downstream, that is, generally opposite to a source of coating material such as a plasma gun apparatus. The electron beam can be defocused or otherwise controlled to help protect the integrity of the work piece. The present invention is suitable for applying thermal barrier coatings (TBCs) to gas turbine engine components, in addition to other uses.

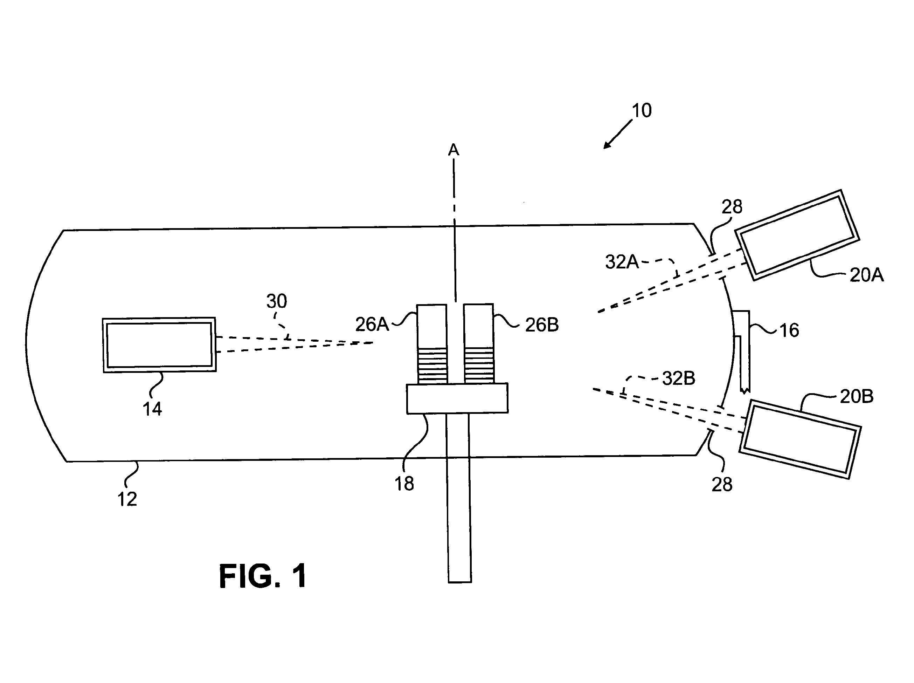

FIG. 1 is a schematic illustration of one embodiment of a coating apparatus 10 that includes a process chamber 12, a plasma gun 14, a pumping assembly 16, a work piece support fixture 18, and electron guns 20A and 20B. One or more work pieces 26A and 26B (collectively referred to by reference number 26) desired to be coated can be secured to the work piece support fixture 18. In the illustrated embodiment, the work pieces 26 are turbine blades for a gas turbine engine, though it will be understood that the work pieces 26 can be nearly any type of component in further embodiments.

The process chamber 12 provides a contained environment for application of the coating material to the work pieces 26. In the illustrated embodiment, the process chamber 12 includes fluid-cooled walls, which can be cooled with water at approximately 15-20°C (60-70°F). Suitable passive thermal insulation (not shown) can be provided adjacent to the walls of the process chamber 12 in a known manner. The process chamber 12 defines an interior space that is held in a vacuum (i.e., a partial vacuum), with the vacuum in the range of approximately 66.66 Pa (0.5 Torr) to approximately 1.33 kPa (10 Torr). Aerodynamic windows 28 are formed through the walls of the process chamber 12 in the illustrated embodiment. The aerodynamic windows 28 can be valve-like structures that provide physical passageways through the walls of the process chamber 12 while still helping to maintain a desired pressure differential (e.g., maintaining the vacuum inside the process chamber 12).

The plasma gun 14 is typically positioned within the process chamber 12. The plasma gun 14 can be of a known type that produces a plasma jet into which a coating material, such as a ceramic TBC powder, is introduced to produce a stream 30 that includes the coating material in a vapor phase. The stream 30 is directed toward the work pieces 26A and 26B and the work piece support fixture 18 to provide plasma-based physical vapor deposition (PVD) coating application. During operation, the plasma gun 14 generates an immense amount of thermal energy within the process chamber 12, with temperatures typically ranging from approximately 871-1093°C (1600-2000°F) near the work pieces 26A and 26B. For a typical ceramic TBC, it is desirable to coat the work pieces 26 at a temperature of approximately 1038°C (1900°F). The plasma gun 14 is the primary source of thermal energy used to heat the work pieces 26 to the desired temperature. It will be appreciated by those of ordinary skill in the art that the particular composition of the coating material can vary as desired for particular applications. For instance, the coating material can be nearly any type of TBC, bond coating, environmental coating, etc. Optimal coating process temperatures can vary for different coating materials. Moreover, in alternative embodiments a different type of coating supply and delivery apparatus can be substituted for the plasma gun 14, as desired for particular applications.

Excess coating material, that is, coating material not deposited on the work pieces 26, can be cooled and collected by the pumping assembly 16. In the illustrated embodiment, the pumping assembly is of a conventional configuration that allows for extraction and collection of excess coating material from the process chamber 12, as well as cooling of that excess coating material. The pumping assembly 16 is typically located at an end of the process chamber opposite the plasma gun 14. Because the pumping assembly 16 cools and removes the excess coating material, an end of the process chamber 12 where the pumping assembly 16 is located tends to exhibit cooler temperatures than in areas near the plasma gun 14.

In the illustrated embodiment, the work pieces 26A and 26B desired to be coated are each secured to the work piece support fixture 18 in the path of the stream 30, downstream from the plasma gun 14. The work piece support fixture 18 can selectively index the work pieces 26 relative to the stream 30 and the plasma gun 14, in order to expose different portions of the work pieces 26 to the stream 30 in a uniform manner so that the coating material can cover all sides of the work pieces 26 substantially equally. In one embodiment, the work piece support fixture 18 is configured to rotate the work pieces 26 about a central axis A. In alternative embodiments, more complex movements of the work pieces 26 are possible, such as planetary- or rotisserie-type movement.

Because portions of the work pieces 26 are rotated away from the plasma gun 14 and the stream 30 (i.e., facing downstream) at times, those portions are generally not heated by the plasma gun 14 and the stream 30 as much as those portions facing the plasma gun 14 and the stream 30 (i.e., facing upstream). Coatings like TBCs are sensitive to thermal conditions during the coating application process, and undesirable thermal conditions can cause detrimental microstructural properties of the TBCs formed on the work pieces 26. In particular, TBCs can develop striations and a cauliflower-like structure if temperature control at or near the work pieces 26 is poor. Moreover, cyclic temperature variations common to prior art coating processes can cause separation between new, hot "layers" of the coating material from the stream 30 and cooler interfaces of previously-applied coating material already deposited on the work pieces 26, making resultant coatings undesirably friable and prone to separation. Temperature variations of 38°C (100°F) or more in process chambers are common with prior art plasma coating processes, and such large temperature variations tend to produce undesirable coating microstructures. As explained further below, the electron guns 20A and 20B can help reduce such temperature variations and help improve the resultant coating microstructure.

The electron guns 20A and 20B can be positioned outside the process chamber 12, and can generate electron beams 32A and 32B, respectively, directed into the process chamber 12 through the aerodynamic windows 28. The electron beams 32A and 32B from the electron guns 20A and 20B directly heat portions of the of work pieces 26A and 26B. The electron guns 20A and 20B can be differentially-pumped. Furthermore, locating the electron guns 20A and 20B outside of the process chamber 12 allows those guns 20A and 20B to be maintained at a different-and typically lower-operating pressure than the vacuum maintained inside the process chamber 12. The electron guns 20A and 20B (as well as the aerodynamic windows 28) can be located near a downstream end of the process chamber 12, near the pumping assembly 16. Each of the electron guns 20A and 20B can have magnetic coils or other mechanisms used to control and direct the electron beams 32A and 32B in a desired manner, such as to allow scanning of the electron beams 32 in a rasterized fashion across portions of the work pieces 26. Typically each electron gun 20 and 20B is directed at one of the work pieces 26A and 26B. The electron beams 32A and 32B can each be defocused, in order to help reduce a risk of causing damage to the work pieces 26A and 26B. The intensity and other parameters of the electron beams 32A and 32B can also be controlled to reduce a risk of damage to the work pieces 26A and 26B during heating.

The electron beams 32A and 32B can be directed at portions of the work pieces 26A and 26B facing downstream. In other words, the work pieces 26 and the work piece support fixture 18 can be positioned generally in between the plasma gun 14 and the electron guns 20A and 20B, with the electron guns 20A and 20B at an opposite side of the work pieces 26 from the plasma gun 14 (i.e., at a downstream side of the work pieces 26 that faces away from the oncoming stream 30).

During operation, the electron guns 20A and 20B direct the electron beams 32A and 32B at downstream portions of the work pieces 26A and 26B, respectively. The electron beams 32A and 32B directly heat portions of the work pieces 26A and 26B. The additional heat generated by the electron beams 32A and 32B helps to thermally stabilize the work pieces 26, and reduce cyclical heat and cooling effects caused by rotation of the work pieces 26 relative to the plasma gun 14 and the stream 30. In other words, the heat that generated by the electron beams 32A and 32B helps reduce or prevent temperature loss as the work pieces 26A and 26B rotate and face an aft, downstream portion of the process chamber 12 where the pumping assembly 16 is located. In some embodiments with multiple work pieces 26A and 26B secured to a common support member 18, such as that shown in FIG. 1, the electron guns 20A and 20B can provide pre-positioned electron beams 32A and 32B that are temporarily shut off when not in position, such as where rotation of the support member 18 obscures one of the work pieces 26A or 26B.

The electron guns 20A and 20B can be positioned such that the electron beams 32A and 32B can reach the work pieces 26A and 26B with a little intersection with the stream 30 as possible, including intersection with related plumes of the coating material present inside the process chamber 12. The coating material in the stream 30 would tend to obstruct the electron beams 32A and 32B and thereby decrease the amount of energy delivered to the work pieces 26A and 26B. By positioning the electron guns 20A and 20B at spaced locations, viewing angles of the electron guns 20A and 20B relative to the work pieces 26A and 26B can be provided so that the electron beams 32A and 32B have at most minimal interaction with the stream 30.

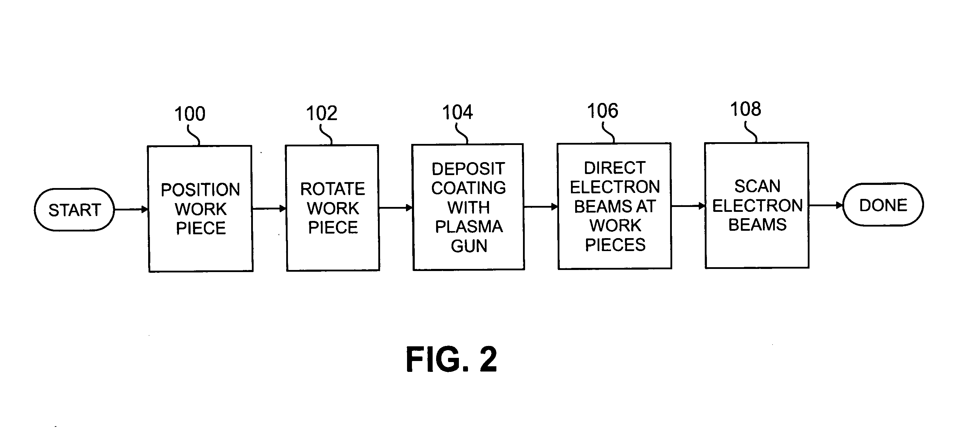

FIG. 2 is a flow chart illustrating one embodiment of a coating method. Work pieces are positioned within a process chamber (step 100). The work pieces are rotated (step 102). A coating material is deposited on the work pieces with a plasma gun assembly that generates a plasma-based vapor stream of the coating material (step 104). While the coating material is being deposited with the plasma gun, and while the work pieces are rotating, electron beams are directed at downstream regions of each of the work pieces to help thermally stabilize the work pieces (step 106). The electron beams can be defocused, and can be scanned across regions of the work pieces (step 108). Those of ordinary skill in the art will appreciate that the method of the present invention can further include additional steps not specifically mentioned.

It will be recognized that the present invention provides numerous advantages and benefits. For example, direct heating provided to work pieces by a electron beams according to the present invention helps reduce or prevent microstructure degradation caused by cyclic cooling and heating of an applied coating as the coating is deposited on those work pieces. More specifically, an approximately 38°C (100°F) or greater surface temperature variation on work pieces can be reduced to approximately 12°C (10°F) or less. Thus, the present invention helps to maintain work pieces at a desired and relatively uniform temperature to help ensure that the deposited coating (e.g., TBC) is of dependably aircraft quality and suitable for flight service. For instance, the present invention can help provide desirable columnar TBC microstructures on work pieces.

While the invention has been described with reference to an exemplary embodiment(s), it will be understood by those skilled in the art that various changes may be made and equivalents may be substituted for elements thereof without departing from the scope of the invention, which is defined by the claims. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A coating system comprising:
a first work piece;
a work piece support for holding the first work piece;
a plasma-based coating delivery apparatus configured to apply a coating material to the first work piece in a plasma-based vapor stream; and
a first electron gun configured to direct a first electron beam at the first work piece while the plasma-based coating delivery apparatus applies the coating to the first work piece for heating the first work piece being coated, wherein the first electron gun is configured to direct the first electron beam at a region of the first work piece facing away from the plasma-based coating delivery apparatus.

2. The coating system of claim 1, wherein the first electron beam is defocused.

3. The coating system of claim 1 or 2, wherein the plasma-based coating delivery apparatus comprises a plasma gun; and preferably wherein the first electron gun is positioned such that the first electron beam is directed to a region of the first work piece facing downstream and away from a vapor stream of the coating material from the plasma gun.

4. The coating system of claim 1, 2 or 3, wherein the work piece support is rotatable to rotate the first work piece relative to the plasma-based coating delivery apparatus.

5. The coating system of claim 1, 2, 3 or 4 and further comprising:
a process chamber, wherein the plasma-based coating delivery apparatus and the first work piece are each positioned at least partially within the process chamber.

6. The coating system of claim 5, wherein an interior of the process chamber is maintained in a vacuum.

7. The coating system of claim 6 and further comprising:
an aerodynamic window defined through a wall of the process chamber, wherein the first electron gun is located outside the process chamber and positioned to direct the first electron beam through the aerodynamic window to the first work piece.

8. The coating system of any preceding claim and further comprising:
a second work piece held by the work piece support;
a second electron gun configured to direct a second electron beam at the second work piece for heating the second work piece being coated; and preferably wherein the plasma-based coating delivery apparatus comprises a plasma gun configured to produce a plasma-based vapor stream of the coating material directed toward both of the first and second work pieces for deposition.

9. The coating system of any preceding claim, wherein the coating material comprises a thermal barrier coating for a gas turbine engine component.

10. A coating method comprising:
positioning a first work piece in a process chamber;
rotating the first work piece;
depositing a coating from a coating supply location onto the rotating first work piece;
heating the first work piece with thermal energy emanating from the coating supply location; and
directing a first electron beam at the first work piece to heat the first work piece being coated, wherein the heat generated by the first electron beam directed at the first work piece thermally stabilizes previously-deposited material of the coating rotated away from the coating supply location emanating thermal energy.

11. The coating method of claim 10, wherein the step of depositing a coating onto the rotating first work piece is performed using a plasma gun to spray the coating in vapor form onto the first work piece in a plasma-based jet.

12. The coating method of claim 10 or 11, wherein the first work piece is rotated more than 360° such that the coating is deposited over previously-deposited material of the coating.

13. The coating method of claim 10, 11 or 12, wherein the first electron beam is defocused.

14. The coating method of claim 10, 11, 12 or 13 and further comprising:
scanning the first electron beam across a surface of the first work piece.

15. The coating method of claim 10, 11, 12, 13 or 14 and further comprising:
directing a second electron beam at a second work piece located in the process chamber.
